# EUROPEAN PATENT SPECIFICATION

(11) **EP 0 890 261 B1**
(45) Date of publication and mention of the grant of the patent: **11.08.2010**
(21) Application number: 96940248.6
(22) Date of filing: 17.10.1996
(51) Int. Cl.: H04N 7/167, H04N 7/171, H04N 5/913

(54) **DIGITALLY REMOVING VIDEO COPY PROTECTION PULSES**
DIGITALE ENTFERNUNG VON VIDEOKOPIERSCHUTZIMPULSEN
ELIMINATION NUMERIQUE D'IMPULSIONS DE PROTECTION ANTI-COPIES EN VIDEO

(30) Priority: 17.10.1995 US 5681
(43) Date of publication of application: 13.01.1999
(73) Proprietor: Rovi Solutions Corporation, Santa Clara, CA 95050 (US)
(72) Inventor: QUAN, Ronald, Cupertino, CA 95014 (US)
(74) Representative: Needle, Jacqueline
(86) International application number: PCT/US1996/016767
(87) International publication number: WO 1997/016022

(56) References cited:
- US-A- 4 336 554
- US-A- 4 577 216
- US-A- 4 626 890
- US-A- 4 695 901
- US-A- 4 742 543
- US-A- 4 819 098
- US-A- 4 907 093
- US-A- 4 937 679
- US-A- 5 157 510
- US-A- 5 194 965

## Description

The present invention relates to a method and apparatus for removing the effects of copy protection signals.

US-A-4,631,603 and US-A-4,819,098 describe methods of copy protecting video signals by adding pulses into blanking intervals. The added pulses may be pairs of pseudo sync and AGC pulses, or a positive pulse may be added immediately following the trailing edge of a normally occurring sync pulse.

US-A-4,695,901, US-A-4,336,554 and US-A-5,194,965, for example, describe methods of defeating such copy protection techniques. For example, US-A-5,194,965 disables the effect of copy protection signals comprising pseudo sync pulses and/or added AGC pulses in the blanking interval of a video signal. The specific method described alters the level of the video signal during the vertical blanking interval, e.g. level-shifting, so as to render the copy protection signals ineffective to prevent unauthorized copying by a VCR. A circuit for achieving the method includes a sync separator for detecting the vertical blanking interval, pulse generating circuits for producing pulses of predetermined widths during the interval, and a summing circuit for summing the predetermined pulses with copy protect signals to thereby shift their level. An alternative method includes increasing the effective frequency of the copy protect signals during the vertical blanking interval so as to achieve attenuation and/or low-pass filtering in the VCR circuitry to thereby render the signals ineffective in preventing copying. A circuit for achieving this method includes pulse narrowing and/or pulse multiplication circuitry which effectively increases the high-frequency content of the pseudo sync and/or AGC pulses.

US patents 5,157,510 and 4,907,093 describe alternate copy protection defeat methods.

US-A-4,577,216 describes a copy protection method in which a colour video signal is modified to inhibit the making of viewable video recordings thereof. A conventional television receiver produces a normal colour picture for the modified signal. However, the resultant colour picture from a subsequent video tape recording shows variations in the colour fidelity that appear as bands or stripes of colour error. These modifications are referred to as the colour stripe system or the colour stripe process. Commercial embodiments of this method typically limit the number of video lines per field which have the induced colour stripes.

Colour video signals (both in the NTSC and PAL TV systems) include what is called a colour burst. The colour stripe system modifies the colour burst. The suppression of the colour subcarrier signal at the TV transmitter requires that the colour TV receiver include (in NTSC) a 3.58 MHz oscillator which is used during demodulation to reinsert the colour subcarrier signal and restore the colour signal to its original form. Both the frequency and phase of this reinserted subcarrier signal are critical for colour reproduction. Therefore, it is necessary to synchronize the colour TV receiver's local 3.58 MHz oscillator so that its frequency and phase are in step with the subcarrier signal at the transmitter.

This synchronization is accomplished by transmitting a small sample of the transmitter's 3.58 MHz subcarrier signal during the back porch interval of the horizontal blanking pulse. The horizontal sync pulse, the front porch and blanking interval duration are essentially the same as that for black and white TV. However, during colour TV transmission (both broadcast and cable) 8 to 10 cycles of the 3.58 MHz subcarrier that is to be used as the colour sync signal are superimposed on the back porch. The colour sync signal is referred to as the colour burst. The colour burst peak-to-peak amplitude is normally the same amplitude as the horizontal sync pulse.

In one commercial embodiment of the colour stripe process, no colour burst phase (stripe) modification appears in the video lines that have a colour burst signal during the vertical blanking interval. These are lines 10 to 21 in an NTSC signal and corresponding lines in a PAL signal. The colour stripe modifications occur in bands of four to five video lines of the viewable TV field followed by bands of eight to ten video lines without the colour stripe modulation. The location of the bands is fixed ("stationary") field-to-field. This colour stripe process has been found to be quite effective for cable television, especially when combined with the copy-protection method of US-A-4,631,603.

In NTSC TV, the start of colour burst is defined by the zero-crossing (positive or negative slope) that precedes the first half cycle of subcarrier (colour burst) that is 50% or greater of the colour burst amplitude. It is to be understood that the colour stripe process shifts the phase of the colour burst cycles relative to their nominal (correct) position.

Further, the amount of phase shift in the colour stripe process can vary from e.g. 20° to 180°; the more phase shift, the greater the visual effect in terms of colour shift. In a colour stripe process for PAL TV, a somewhat greater phase shift (e.g. 40° to 180°) is used to be effective.

Methods and apparatus for defeating the effects of the colour stripe process are described in US-A-4,626,890.

US-A-4 695,901 discloses a method of removing the effects of copy protection signals within a video signal, where the copy protection signals inhibit the making of viewable analog video recordings of the video signal.

The present invention seeks to provide an alternative method for removing the effects of copy protection signals in a video signal.

According to a first aspect of the present invention a method of removing the effects of copy protection signals within a video signal is provided where the copy protection signals inhibit the making of viewable analog video recordings of the video signal, the method comprising the steps of:
determining in which lines of the video signal the copy protection signals are present; counting a predetermined number of lines in a vertical blanking area of the video signal in which the copy protection signals are present;
modifying the copy protection signals whilst in the digital domain in at least some of the lines in which the copy protection signals are present to allow a viewable video recording of said digital video signal to be made after digital to analog conversion, wherein the step of modifying the copy protection signals comprises modifying less than all of the lines in which the copy protection signals are present, but modifying sufficient of the lines to enable the making of a viewable video recording; and
outputting control signals coincident with said copy protection signals. Video signals exist in both the analog domain and the digital domain.

This invention proposes reducing the effectiveness of copy protection signals by removing the copy protection whilst the video signal is in the digital domain. A video pirate may attempt to avoid infringement of one or more of the analog defeat mechanisms referred to above by converting the analog signal to the digital domain and instituting defeat mechanisms in the digital domain.

It has now been determined that the analog defeat mechanisms described above can be improved upon by the use of digital techniques and by defeating the effects of the analog copy protection signals whilst the video signal is in the digital domain.

A method of an embodiment of the invention is effective both to remove pseudo sync and AGC pulses, and to eliminate the effects of the colour stripe process.

The present invention also extends to apparatus for removing the effects of copy protection signals within a video signal, where the copy protection signals inhibit the making of viewable analog video recordings of the video signal; the apparatus comprising:
a digital processor for receiving a digital video signal containing copy protection signals; a digital copy protection signal location detector for determining in which lines of the video signal the copy protection signals are present; and a location circuit for digitally counting a predetermined number of lines in which the copy protection signals are present and for outputting control signals indicative of the presence of said copy protection signal; and
a digital signal modification circuit responsive to said control signals for modifying the copy protection signals whilst in the digital domain in at least some of the lines in which the copy protection signals are present to allow a viewable video recording of said digital video signal to be made after digital to analog conversion.

A digital video copy protection eliminator allows removal of substantially all or sufficient portions of pseudo sync pulses and/or AGC pulses in the digital domain. The location of pseudo syncs and/or AGC pulses are determined, while the signal is in the digital domain. These known pixel locations of all or some of the pseudo syncs and/or AGC pulses are used to digitally multiplex (preferably fixed) numbers into a digital multiplexer so as to effectively remove the pseudo sync pulses and/or AGC pulses. The digital processing may contain luminance/chrominance separators and either the luminance and/or chrominance digital parts can be used to locate the pseudo sync and/or AGC pulse TV line pixel locations. For example, the luminance portion would contain vertical sync as a start point to count lines in the vertical blanking area where the copy protection signals reside. Also the chrominance signals would have a digital colour burst that starts in each vertical blanking interval so as to locate the copy protection signals in the vertical blanking interval. The effective elimination of these copy protection pulses can be done to the digital composite signal or just to the luminance signal (Y).

Once the copy protection pulses have been located, a generic way of effectively eliminating the copy protection pulses in the digital domain is done via a "circuit ACP". "Circuit ACP" is controlled by the pseudo sync AGC pulse pixel location circuit and can be right before the digital processing or within the digital processing block.

The "circuit ACP" eliminates effectively copy protection in the digital domain by: a) level shifting and/or pulse narrowing and/or pulse attenuation as described in US patents Nos. 4,695,901, 5,194,965 and 5,157,510; b) normal composite sync replacement; c) increased normal composite sync size that is larger in amplitude than the pseudo sync such that sync separators will not detect pseudo syncs; and d) replacement of at least part of pseudo AGC locations with a signal (i.e. flat field) such that a recordable copy is possible.

Several different circuits which can be used as "circuit ACP" are described. Other "circuit ACP" variations can be circuits which turn logic high by sensing the copy protected video's AGC and pseudo sync pulses. Then using timing generators to output pulses shorter in duration than the AGC and pseudo syncs, which in turn are used to narrow the video signal's AGC pulses and pseudo sync pulses. Of course the copy protection pulses may also be a combination of narrowing, attenuation, level shifting and/or modification (i.e. replacement).

This method (and apparatus) is applicable to digital processors such as computer desk top video, digital video tape recording, digital video effects, etc.

Digital methods can also be applied to effectively eliminate or correct the colour stripe protection process and/or enhanced video copy protection signals in the digital domain.

The digital signal may be defined by the relative 8 bit levels of a video signal. For instance, sync tip is defined as 0 and peak white is level 255. Colour burst is between level 36 and 109, and blanking level is at 73. The colour stripe signal as described needs to have enough of the phase shifted colour burst corrected to allow acceptable recording to be made. For instance if the phase shift is set for 180 degrees, an EPROM (erasable programmable memory), is used to map the colour burst level numbers to new ones that is a mirror image around level 73 (blanking level). For instance if the burst level from the video source is level 109, the output of the EPROM will be level 36.

The methods and apparatus for digitally removing or defeating effects of copy protection signals include modifying less than all of the lines in which the copy protection signals are present, but sufficient of the lines so that the viewable video recording can be made. Also defeating can include modifying sufficient portions of AGC pulses, pseudo sync pulses and/or chroma copy protection signals for a recordable copy.

Embodiments of the present invention will hereinafter be described, by way of example, with reference to the accompanying drawings, in which:
Figure 1A shows a copy protection signal including pseudo sync pulses and AGC pulses;
Figure 1B shows an alternative copy protection signal;
Figure 2 shows a signal path of a video signal in the digital domain;
Figure 3 shows a block diagram of a first embodiment of the invention;
Figure 4 shows a block diagram of a second embodiment of the invention;
Figure 5 shows a combination analog and/or digital circuit;
Figure 6 shows the relative 8 bit levels of a video signal;
Figure 7 shows an eight bit digital phase invertor;
Figure 8 shows a digital sync separator circuit;
Figure 9 shows a digital timing pulse generator;
Figure 10 shows a block diagram showing the generation of colour stripe line location and burst gate generation;
Figure 11 shows a multiplexing embodiment of defeating the effects of colour stripe;
Figure 12 shows an embodiment of defeating the effects of colour stripe by using a digital burst continuation oscillator.
Figure 13 shows an embodiment using a digital phase detector; and
Figure 14 shows an embodiment of detecting colour stripe burst without using a phase detector.

The following describes a number of embodiments to defeat the effects of analog copy protection signals while the signal is in the digital domain.

There are two basic types of copy protection signals which are commonly present in video signals. The first type includes signals in the luminance portion of the video signal. The second type includes copy protection in the chrominance portion of the video signal.

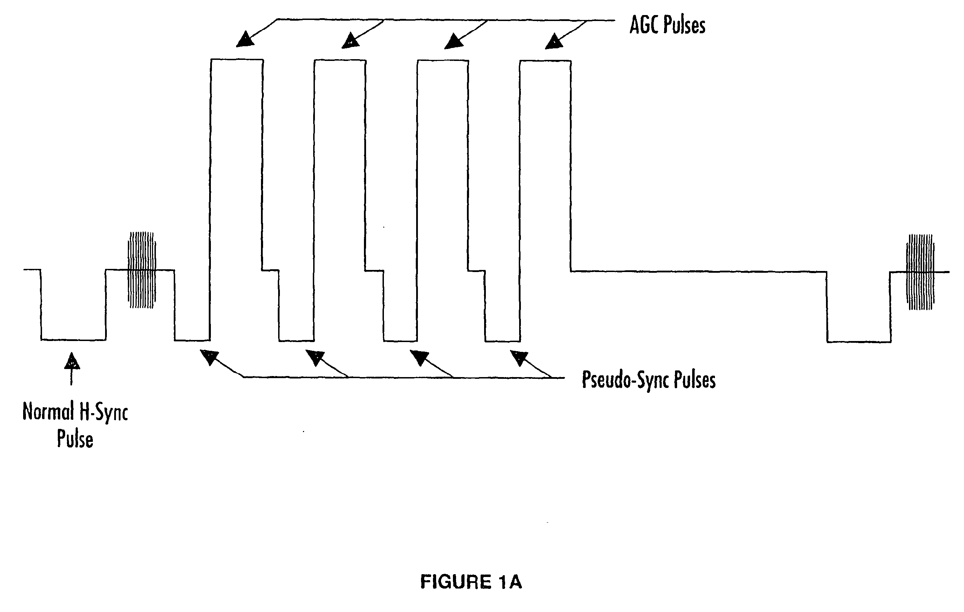

Figure 1A shows a copy protection signal, for example, as described in US-A-4,631,603. The video signal as shown in Figure 1A has been modified so that a television receiver will still provide a normal colour picture from the modified video signal whilst a videotape recording of the modified video signal produces generally unacceptable pictures.

This copy protection technique relies on the fact that the typical videocassette recorder's automatic gain control systems cannot distinguish between normal sync pulses (including equalizing or broad pulses) of a conventional video signal and added pseudo sync pulses. Pseudo sync pulses are defined here as pulses which extend down to a normal sync tip level and which have a duration of at least 0.5 microseconds. A plurality of such pseudo sync pulses is added to the conventional video during the vertical blanking interval, and each of such pseudo sync pulses is followed by a positive AGC pulse of suitable amplitude and duration. As a result, the automatic gain control system in a videotape recorder will make a fake measurement of video level which causes an improper recording of the video signal. The result is unacceptable picture quality during playback. This approach utilizes positive-going pulses which occur at a time not ordinarily used for black level restoration in typical television receivers, and therefore does not give rise to black level depression in such typical television sets.

US-A-4,819,098 describes a modification of a video signal in which a positive pulse is added immediately following the trailing edge of a normally occurring sync pulse. These added pulses are clustered at the vertical blanking interval of each field to minimize the affect of the same on the viewability of the picture defined by the signal whilst still causing the automatic level control circuit in a recorder to assess the video level at many times its actual value. The sync pulses themselves can also be at a reduced level, in order to enhance the effectiveness of the process.

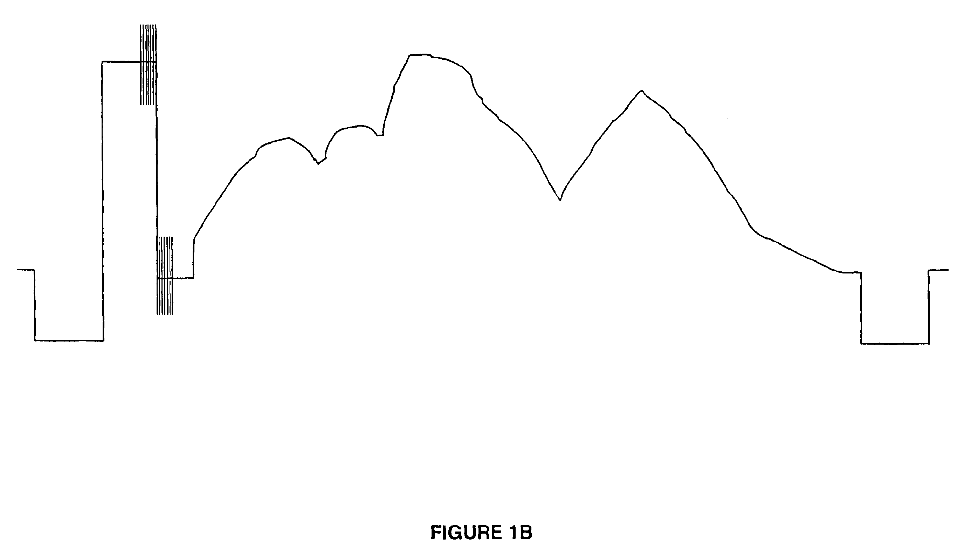

Figure 1B illustrates the waveform of that portion of a typical colour video signal responsible for one horizontal scan trace and return. It shows the sync pulse with the reduced level and the immediately following positive pulse. The colour burst is also shown.

As stated, the copy protection signals have a combination of either a pseudo sync or a regular sync pulse with an AGC pulse. These pairs of sync and AGC pulses are designed to cause the AGC circuitry in a recorder to miscalculate the proper gain setting and thus make an inferior recording.

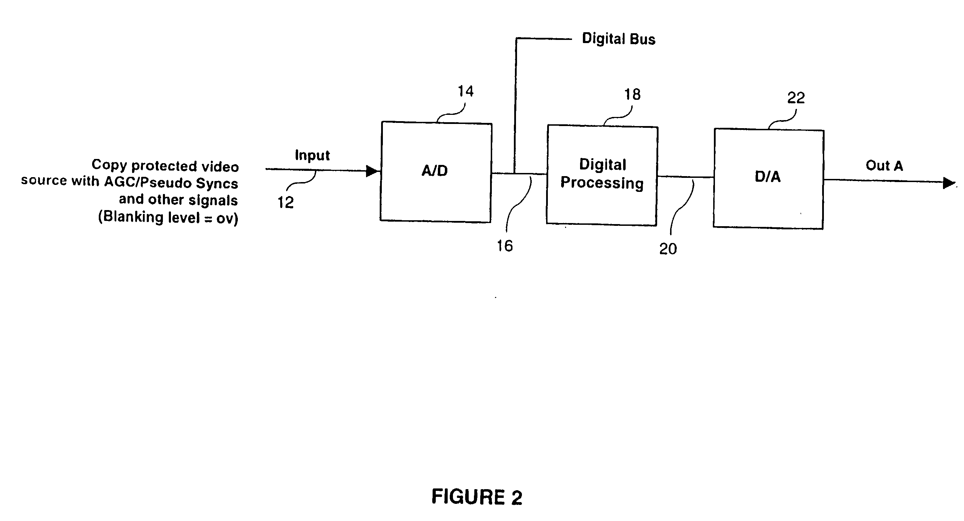

Figure 2 shows the conversion of a copy protected analog signal into the digital domain so that the effects of the copy protection can be reduced or eliminated. As illustrated, an analog signal 12 containing copy protection signals is converted to a digital signal 16 using an analog to digital converter 14. The digital signal 16 can then be processed in the digital domain. The processed digital signal 20 is then converted back to the analog domain by a digital to analog converter 22.

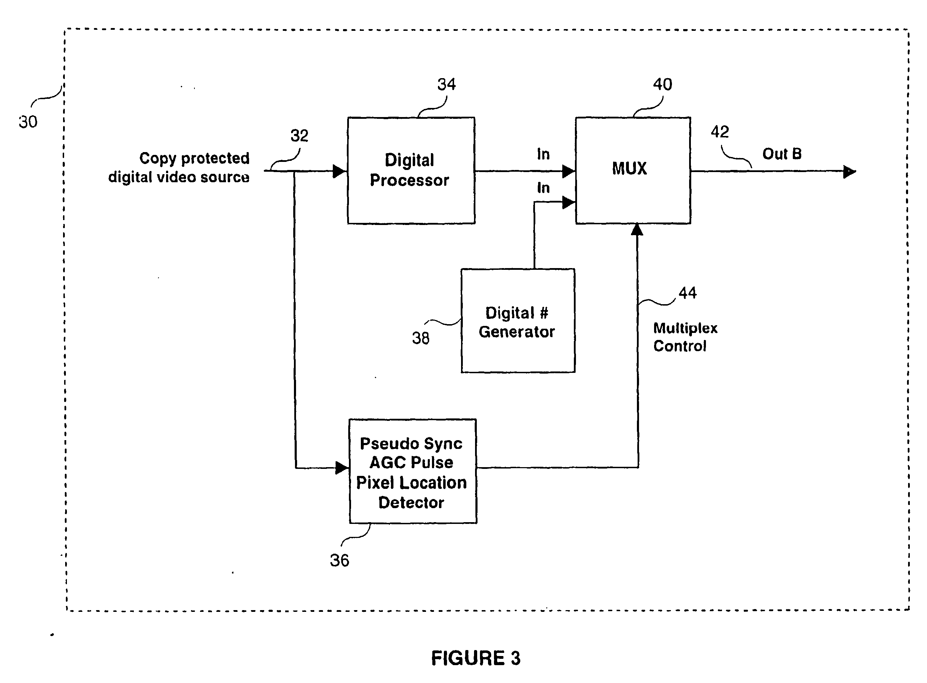

Figure 3 shows a first embodiment of apparatus for removing the effects of copy protection from a digital signal which may, or may not, have been converted from an analog signal.

As shown in Figure 3, a copy protected digital video input signal 32 is input to a digital processor 34 of the apparatus 30. The signal 32 is also input to a pseudo sync AGC pulse location circuit 36. A digital number generator 38 generates a predetermined digital number representing a condition desired as a replacement for the copy protection pulses. The outputs of the digital processor 34 and the digital number generator 38 are applied to first and second inputs of a digital multiplexer 40. An output of the pseudo sync AGC pulse location generator 36 is input to the digital multiplexer 40 as a control signal for the digital multiplexer 40. The resulting digital video signal 42 output from the digital multiplexer has had the pseudo sync AGC signals modified or removed as instructed by the control signal 44.

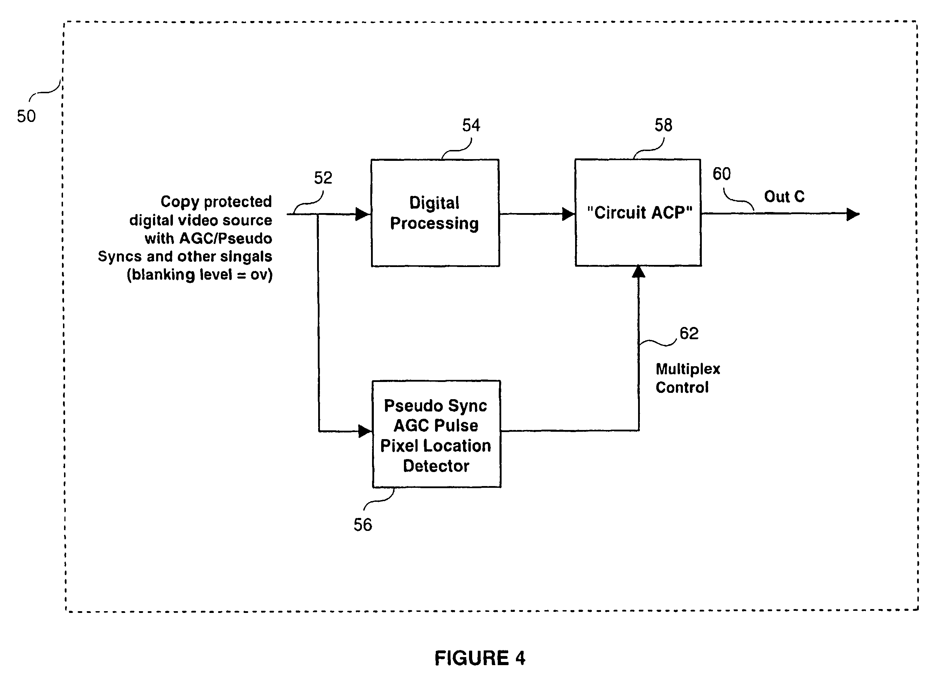

A second embodiment of apparatus 50 for removing the effects of copy protection is illustrated in Figure 4. As shown, a copy protected digital video input signal 52 is input to a digital processor 54 and to a pseudo sync AGC pulse location circuit 56. The output of the digital processor 54 is applied to a first input of a generic circuit called "circuit ACP" 58. An output of the pseudo sync AGC pulse location circuit 56 is input to a second input of "circuit ACP" 58. The details of various embodiments of "circuit ACP" 58 are described below. The resulting digital video signal 60 output by the "circuit ACP" 58 has had the pseudo sync AGC signals modified or removed as instructed by a multiplex control signal 62 and the "circuit ACP" 58.

The various functions that the "circuit ACP" performs are:
a) Level shifting and/or pulse narrowing and/or pulse attenuation of the added copy protection pulses, for example, as described in US-A-4,695,901, US-A-5,194,965, and US-A-5,157,510;
b) Normal composite sync replacement;
c) Increased normal composite sync size that is larger in amplitude than the pseudo sync such that sync separators in recorders will not detect pseudo syncs as described in US-A-5,194,965; and
d) Replacement or modification of at least part of pseudo sync and AGC locations with a signal (i.e. flat field) such that a recordable copy is possible.

Note that the digitally derived multiplex control signal 62 shown in Figure 4 can be used to activate analog circuitry at the input analog input or output so as to defeat the copy protection pulses.

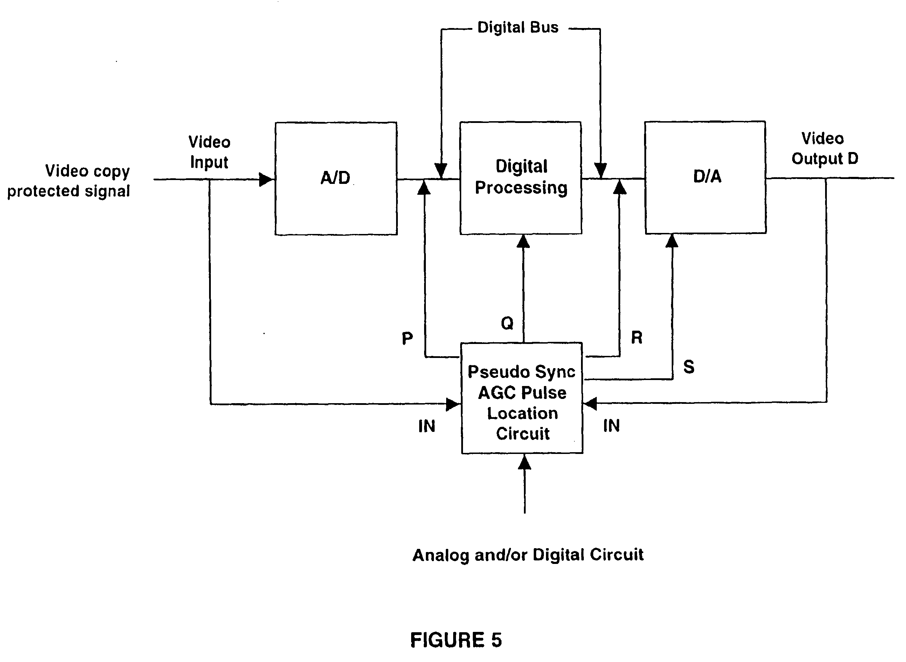

Figure 5 shows a combination analog and/or digital circuit, which may comprise sync separators, one shot timing circuits, logic, or counters and digital line location, and which samples the analog video input and/or the analog video output D to generate pulses coincidental to pseudo syncs and/or AGC pulses. The outputs of this circuit are the combination of P, Q, R, S which effectively eliminate the video anticopy pulses in the digital domain. For example "Q" can be a pulse coincidental with the video lines associated with the added copy protection pulses. "Q" can be used to switch off, attenuate, level shift, or narrow the added copy protection pulses so as to make a recordable VCR copy or to substantially eliminate the copy protection.

Digital methods can also be used to effectively eliminate or correct the "colour stripe" (burst phase modulation) protection process and/or enhanced video copy protection signals in the digital domain.

In the colour stripe process for preventing recording of video signals, the colour burst present on each line of active video is modified so that any subsequent video tape recording of the video signal shows variations in the colour fidelity that appear as undesirable bands or stripes of colour errors. This colour stripe process is defeated first by determining the location of the video lines which include the colour stripe process. This can be done either by prior experimentation or by on-line detection. Then some or all of the lines including the modified colour bursts are modified so as to render the overall video signal recordable. The modification is accomplished in a number of ways. For example, the colour stripe burst may be phase shifted into the correct phase. Some of the colour stripe bursts or a portion of particular colour stripe bursts may be replaced so that they are not longer effective. Additionally or alternatively, the colour stripe burst may be mixed with colour stripe signals of the correct phase so as to eliminate most or all of the phase error present. The modified colour bursts are defeated, in other versions, by modifying the horizontal sync pulse signals immediately preceding the modified colour bursts so that the modified colour bursts are not detected by a VCR and hence have no effect.

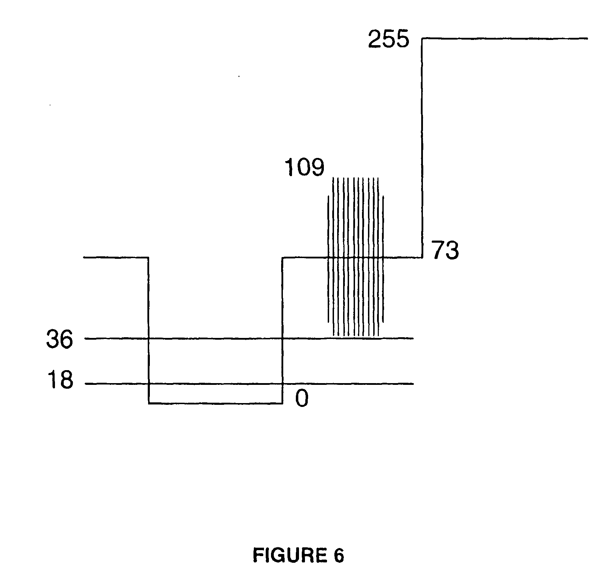

Figure 6 shows the relative 8 bit levels of a digital video signal. For instance, sync tip is defined as 0 and peak white is level 255. Colour burst is between level 36 and 109, and blanking level is at 73. Other bit rates are possible. An 8 bit signal is used as an exemplary version. The colour stripe signal as described needs to have enough of the phase shifted colour burst corrected to allow acceptable recording to be made. For instance if the phase shift is set for 180 degrees, an EPROM (erasable programmable memory), is used to map the colour burst level numbers to new ones which are a mirror image around level 73 (blanking level). For example, if the burst level from the video source is level 109, the output of the EPROM will be level 36.

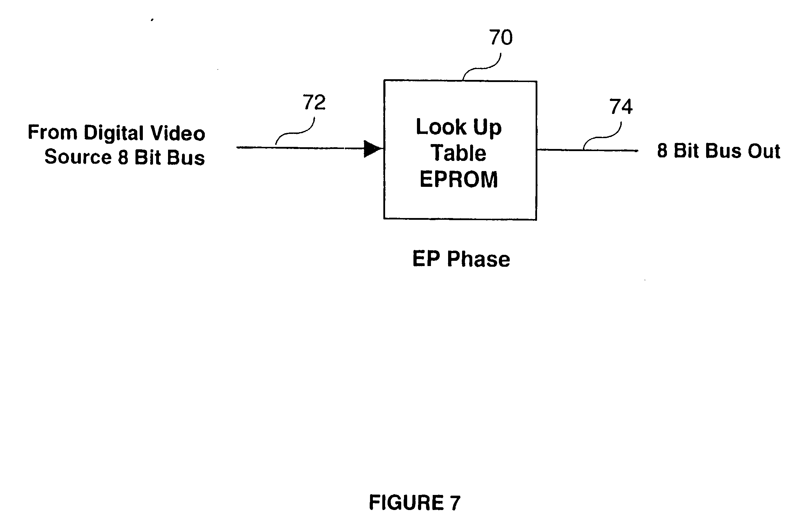

Figure 7 shows a way to create a phase shift for digitized colour burst. For instance if the phase shift is set for 180 degrees, EPROM (erasable programmable memory) 70 will map the colour burst level numbers to new ones which are a mirror image around level 73 (blanking level). For instance if the burst level from the video source 72 is level 109, the output of EPROM 70 will be level 36.

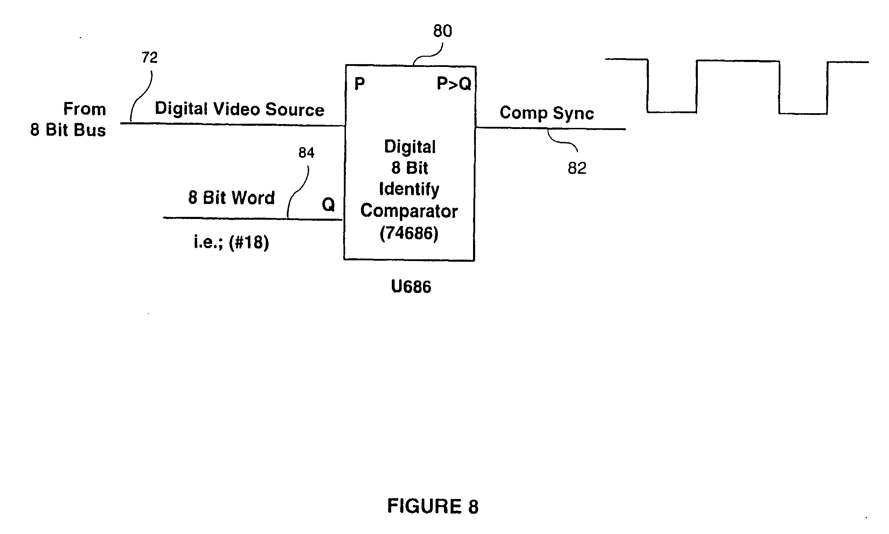

Figure 8 shows a digital sync separator circuit. The digital video source (i.e. 8 bit bus) is input into the "P" input of a digital 8 bit identity comparator 80, for example, such as the 74686 circuit from Texas Instruments. The Q input is an 8 bit word such as 18. The output of the comparator 80 will be high when the digital video source is greater than level 18. As seen on Figure 8, the output of comparator 80 is a waveform representing composite sync, which includes pseudo sync.

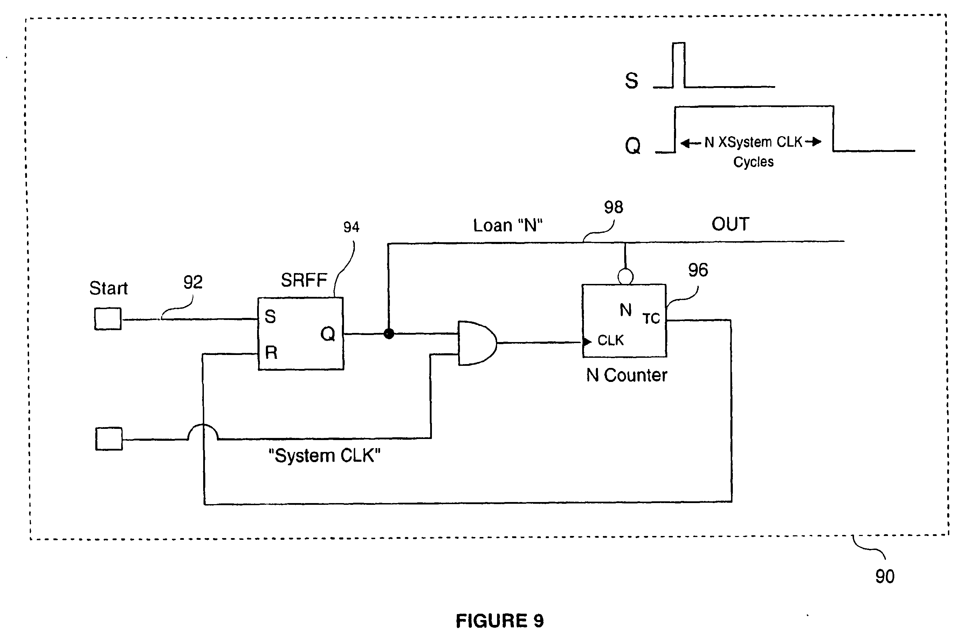

Figure 9 shows a digital timing pulse generator 90 which is equivalent to a very precise one shot multivibrator. An incoming pulse 92 is used to trigger the start input of a flip flop 94 such that the flip flop's Q output is high. This allows a system clock, for example, a pixel clock such as 14.318 MHz in NTSC, to start a counter 96 to count to N. When the counter 96 reaches N, its output resets the flip flop 94 such that its Q output goes low and loads N into the counter 96 to reset the counter. The output of the flip flop 94 is a pulse 98 which is equal to N times the system clock duration.

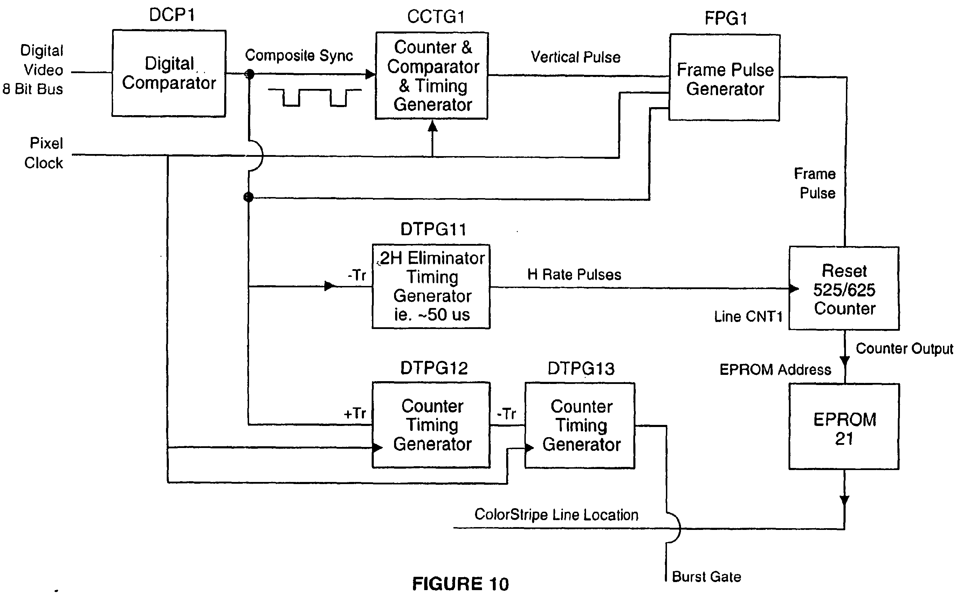

Figure 10 shows apparatus for locating TV lines having colour stripe and for generating burst gate pulses. A copy protected digital video is typically an 8 (to 10) bit bus which is input into a digital comparator DCP1 to sense sync pulses. The output of the comparator DCP1 is then composite sync, including pseudo sync pulses. The composite sync output is fed to a counter and comparator CCTG1 which senses the vertical sync pulses, for example, the first vertical broad pulse (in NTSC line 4 in field 1 and last half of 266 in field 2). See ANSI/SMPTE Standard 170M-1994, Figure 7. The pixel clock (i.e. 14.318 MHz in some NTSC systems) is used in the counter and comparator CCGT1 to count pulses which would sense the vertical sync broad pulse. The output of the counter and comparator CCTRG1 is then a pulse high with each first vertical sync pulse. This then feeds into a frame pulse generator circuit FPG1. The frame pulse generator circuit also receives the composite sync output from the comparator DCP1 and the pixel clock signal. The frame pulse generator circuit FPG1 uses the vertical pulse from the counter and comparator CCGT1 to start a digital one shot with the pixel clock to last about 6 lines. Then another digital one shot in the frame pulse generator circuit FPG1 triggers the end of the 6 lines one shot for about 3 microseconds. This 3 microsecond one shot is then high during the horizontal sync pulse timing of line 10 field one, and the 3 microsecond one shot is high during the middle of line 272, field 2. The frame pulse generator circuit FPG1 uses combination logic to "and" the 3 microsecond one shot output with the composite sync from the comparator DCP1. During field 1, the output of this "and" gate in the frame pulse generator circuit FPG1 is low (because line 10's sync pulse is a logic low). During field 2, the output of this "and" gate is high because line 272 is logic high in the middle of its line with sync separated via the comparator DCP1. The output of the frame pulse generator circuit FPG1 is then a pulse that is high for even fields and low for odd fields.

Composite sync is fed to about 50 microsecond non retriggerable digital one shot DTPG11. The output of the one shot DTPG11 then is horizontal rate pulses. The output of the one shot DTPG11 is fed to the clock input of a counter LINECNT1 with the output of the frame pulse generator circuit FPG1 applied to reset this counter LINECNT1. The counter LINECNT1 output is multibit that counts to 525 in NTSC or 625 in PAL or SECAM. The output of the counter LINECNT1 is fed to the address input of an EPROM 21. The output of the EPROM 21 is programmed such that a logic high is on during the identified lines containing colour stripe.

To generate a burst gate, composite sync from the comparator DCP1 is fed to digital one shot or delay circuit DTPG 12. The circuit DTPG12 is timed for its trailing edge to coincide with the start of colour burst. The output of the circuit DTPG12 then triggers a timing generator DTPG13 to generate a pulse that is coincident with the colour burst.

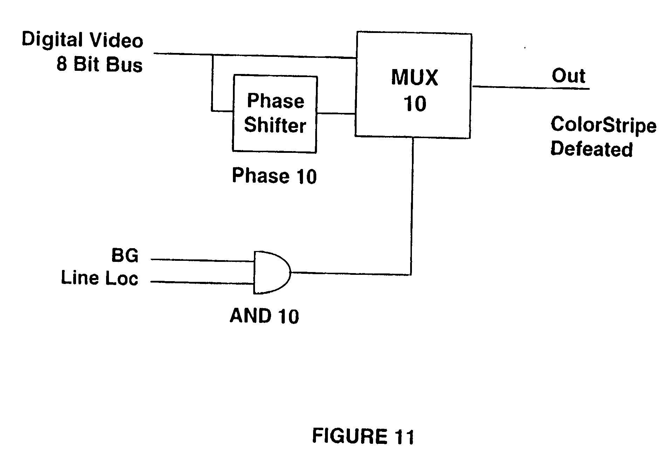

Figure 11 shows how to remove the effects of the colour stripe process by multiplexing via a digital multiplexer MUX10. The digital video signal is supplied to the multiplexer MUX10 and also to a phase shifter Phase 10 which is also connected to a second input of the multiplexer MUX10. An and gate AND10 receives a burst gate signal BG, and a colour stripe line location signal Line Loc. The output of the and gate AND10 is applied to a third input of the multiplexer MUX10. The burst gate signal and colour stripe line location signal are Anded by the and gate. The multiplexer MUX10 is caused to switch a corrected colour burst phase signal from the phase shifter Phase 10 into the digital video signal which results in a recordable video with the colour stripe process defeated.

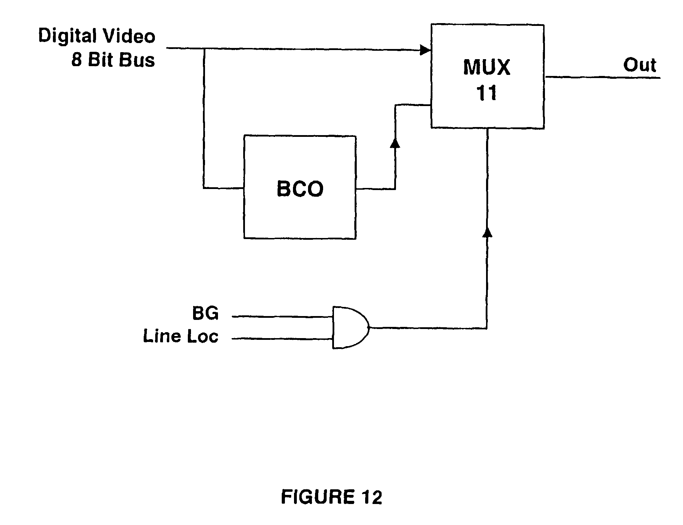

Figure 12 shows another way of defeating colour stripe by using a digital burst continuation oscillator, BCO, (See Philips Desktop Video Data Handbook (1992) page 2-26). The digital video bus is input into the oscillator BCO. The output of the oscillator BCO is input into a multiplexer MUX11. Control of the multiplexer MUX11 can be BG, burst gate from Figure 10 to replace all burst with corrected colour digital burst. Using the colour stripe line location pulse and burst gate, the multiplexer MUX11 can replace only those colour stripe colour bursts with corrected colour bursts in the digital domain. Either way, a recordable copy can be made.

There are several methods that can be used for a digital phase detector. The first one is seen at page 2-17 of the Philips 1992 Desktop Video Data Handbook published by Philips Semiconductors.

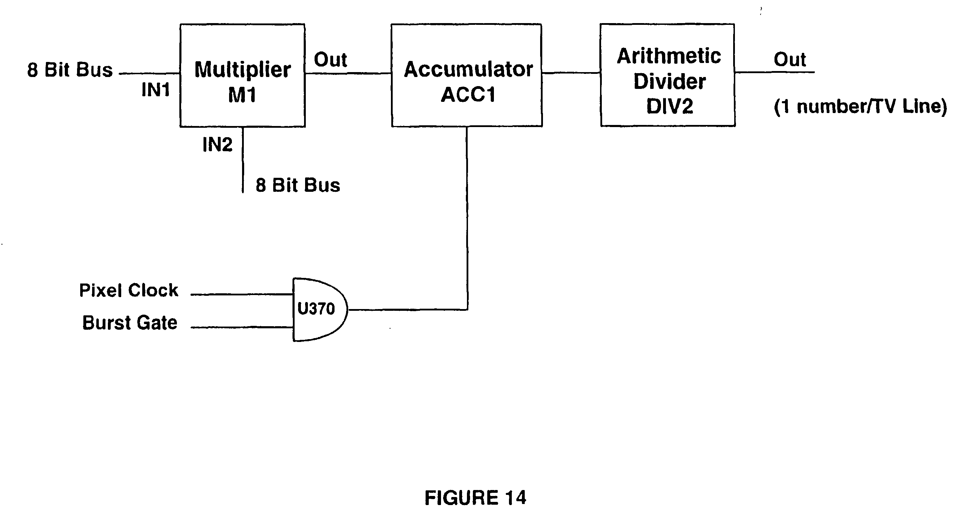

A second example is Figure 14. There is input to a digital multiplier M1; a first input IN1 which is digital video containing colour stripe bursts, and a second input IN2 which is for the colour burst digital burst continuation circuit, for example, an oscillator or a correct burst replication circuit in the digital domain. The output of the multiplier M1 is the product of the inputs IN1 and IN2. The multiplier M1 is a digital arithmetic multiplier such as a circuit using Texas Instruments 74284 and other integrated circuits. The output of the multiplier M1 is the product of inputs IN1 and IN2 at pixel rate. An accumulator ACC1 sums the output of the multiplier M1 for up to 32 times, representing up to 8 subcarrier cycles, via output of U370. The output of the accumulator ACC1 is arithmetically divided by way of a divider DIV2, by, for example, 32, to result in the average of the output of the multiplier M1. The output of the divider DV2 is a number that occurs once a line when colour burst is present, either colour stripe or normal burst. For those lines containing colour stripe, the output of the divider DIV2 will be differently detectable from those lines containing normal colour burst.

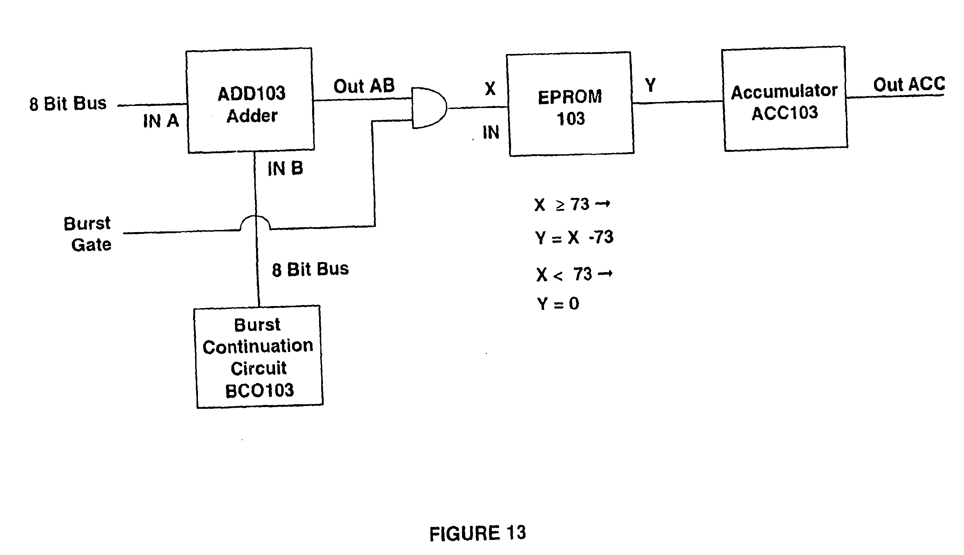

Another embodiment of apparatus to detect colour stripe burst without using a phase detector is shown in Figure 13 which uses an adder ADD103. The output of the burst continuation circuit, which represents the correct burst phase, is added to the burst signal each horizontal line. With lines of correct colour burst phase, the output of the adder ADD103 will be twice the amplitude of the colour burst. If, however, lines containing colour stripe burst are present, the output of the adder ADD103 will be much smaller than twice the amplitude of the colour burst. The output of the adder ADD103 is gated by way of an AND gate and applied to an EPROM 103. The EPROM 103 is programmed to clip off the levels below blanking and subtract off blanking level (#73). The output of the EPROM 103 is fed to accumulator ACC103 to sum the numbers (about 32 for 8 cycles of colour burst). If colour stripe is present, the number from the accumulator ACC103 (one number per horizontal line) will be lower than if correct colour burst were present.

It will be appreciated that modifications and variations may be made to the embodiments described and illustrated within the scope of the appended claims. Specifically, the examples described above have referred to video signals in the NTSC format. However, the invention is also applicable to the PAL and SECAM formats.

## Claims

1. A method of removing the effects of copy protection signals within a video signal, where the copy protection signals inhibit the making of viewable analog video recordings of the video signal, the method comprising the steps of:
determining in which lines of the video signal the copy protection signals are present;
counting a predetermined number of lines in a vertical blanking area of the video signal in which the copy protection signals are present;
modifying the copy protection signals whilst in the digital domain in at least some of the lines in which the copy protection signals are present to allow a viewable video recording of said digital video signal to be made after digital to analog conversion, wherein the step of modifying the copy protection signals comprises modifying less than all of the lines in which the copy protection signals are present, but modifying sufficient of the lines to enable the making of a viewable video recording; and
outputting control signals coincident with said copy protection signals.

2. A method as claimed in Claim 1, wherein the step of modifying comprises:
inputting a digital video signal to a first signal input of a multiplexer;
inputting a digital number into a second signal input of said multiplexer;
and
inputting said control signal into a control input of said multiplexer.

3. A method as claimed in Claim 1, wherein the step of modifying comprises the steps of:
inputting the control signal to a digital copy protection modifying circuit during the presence of copy protection signals within the video signal; and
controlling the amplitude of portions of the video signals to remove the effects of the copy protection signals.

4. A method as claimed in Claim 3, wherein the step of controlling the amplitude comprises reducing the amplitude of portions of the digital video signal during the presence of copy protection signals.

5. A method as claimed in Claim 3, wherein the step of controlling the amplitude comprises increasing the amplitude of portions of the digital video signal during the absence of copy protection signals within the video signal.

6. A method as claimed in Claim 1, wherein the step of modifying comprises the steps of:
inputting the control signal to a digital copy protection modifying circuit during the presence of copy protection signals within the video signal; and
replacing the copy protection signals with a digital replacement signal.

7. A method as claimed in Claim 6, wherein the replacement signal is a digital signal representing the blanking level of said video signal.

8. A method as claimed in any preceding claim, wherein the copy protection signals are pseudo sync and AGC pulse pair copy protection signals, and wherein the copy protection signals are modified by increasing the amplitude of normal sync pulses relative to pseudo sync pulses whilst in the digital domain.

9. A method as claimed in any of Claims 1 to 7, wherein the copy protection signals within the video signal are chroma copy protection signals of improper phase, and wherein the copy protection signals are modified by replacing the chroma copy protection signals with chroma signals of a proper phase.

10. A method as claimed in Claim 9, wherein the location of the chroma copy protection signals is determined by determining the lines in which the chroma copy protection signals are located and locating a burst gate signal indicative of the start of a colour burst.

11. Apparatus for removing the effects of copy protection signals within a video signal (12, 32, 52), where the copy protection signals inhibit the making of viewable analog video recordings of the video signal;
the apparatus comprising:
a digital processor (34, 54) for receiving a digital video signal (12, 32, 52) containing copy protection signals;
a digital copy protection signal location detector (36, 56) for determining in which lines of the video signal the copy protection signals are present;
a location circuit for digitally counting a predetermined number of lines in which the copy protection signals are present and for outputting control signals indicative of the presence of said copy protection signal; and
a digital signal modification circuit (40, 58) responsive to said control signals for modifying the copy protection signals whilst in the digital domain in at least some of the lines in which the copy protection signals are present to allow a viewable video recording of said digital video signal to be made after digital to analog conversion.

12. Apparatus as claimed in Claim 11, where the copy protection signals are pseudo sync and AGC pulses, wherein the digital signal modification circuit comprises a digital anti-copy protection circuit (58) for removing the copy protection signals.

13. Apparatus as claimed in Claim 12, wherein said anti-copy protection circuit comprises means for level shifting the pseudo sync pulses relative to normal sync pulses to modify the copy protection signals.

14. Apparatus as claimed in Claim 12, wherein said anti-copy protection circuit comprises means for pulse narrowing said pseudo sync pulses and said AGC pulses.

15. Apparatus as claimed in Claim 12, wherein said anti-copy protection circuit comprises means for replacing all pseudo sync pulses with normal sync pulses.

16. Apparatus as claimed in Claim 12, wherein said anti-copy protection circuit comprises means for increasing the amplitude of normal sync pulses relative to pseudo sync pulses.

17. Apparatus as claimed in Claim 11, where the copy protection signals are chroma copy protection signals of improper phase within the video signal, and
the digital signal modification circuit comprises a digital multiplexer (40, MUX10, MUX11).

18. Apparatus as claimed in Claim 17, wherein said digital copy protection signal location detector (36, 56) comprises:
a digital comparator (DCP1) for receiving said digital video signal containing said chroma copy protection signals and arranged to generate a composite sync;
a counter/comparator/timing generator (CCTG1), a 2H eliminator timing generator (DTPG11) and a first counter timing generator (DTPG12), all responsive to the composite sync;
a frame pulse generator (FPG1) responsive to a pixel clock along with the counter/comparator/timing generator and the first and second counter timing generator circuit (DTPG13) responsive to the pixel clock;
wherein said counter/comparator/timing generator generates a vertical pulse which is coupled to said frame pulse generator;
said pixel clock, said vertical pulse and composite sync signals being coupled to said frame pulse generator to produce a frame pulse;
a reset 525/625 counter (CNT1) responsive to the frame pulse for producing an EPROM address;
wherein said 2H eliminator timing generator produces horizontal rate pulses and is coupled to said reset 525/625 counter;
an EPROM (21) responsive to the EPROM address and programmed such that a selected logic state is indicative of lines containing said chroma copy protection signals;
wherein said first and second counter generators combine to produce a burst gate signal on an output of said second counter timing generator.

19. Apparatus as claimed in Claim 17, wherein said digital signal modification circuit comprises:
a digital multiplexer (MUX10, MUX11) for receiving said video signal containing the chroma copy protection signals;
a digital phase shifter (Phase 10) arranged to apply the video signal to a second input of the digital multiplexer; and
an AND gate (AND10) responsive to a burst gate signal (BG) and a copy protection line location signal (Line Loc) for supplying a control signal to a third input of the digital multiplexer for controlling the time periods during which a phase shifted digital video signal is coupled to the output of the digital multiplexer.

## Patentansprüche

1. Verfahren zum Entfernen der Effekte von Kopierschutzsignalen in einem Videosignal, wobei die Kopierschutzsignale das Erstellen von ansehbaren analogen Videoaufzeichnungen des Videosignals erschweren, und wobei das Verfahren die Schritte umfasst:
Bestimmen, in welchen Zeilen des Videosignals die Kopierschutzsignale vorhanden sind;
Zählen einer vorbestimmten Zahl von Zeilen in einem vertikalen Ausblendgebiet des Videosignals, in dem die Kopierschutzsignale vorhanden sind;
Modifizieren der Kopierschutzsignale, während sie sich in der digitalen Domäne in mindestens einigen der Zeilen befinden, in denen die Kopierschutzsignale vorhanden sind, um das Erstellen einer ansehbaren Videoaufzeichnung des digitalen Videosignals ermöglicht wird, und zwar nach einer Digital-Analog-Umwandlung, wobei der Schritt des Modifizierens der Kopierschutzsignale das Modifizieren von weniger als all jenen Zeilen, in denen die Kopierschutzsignale vorhanden sind, aber das Modifizieren einer ausreichenden Zahl von Zeilen umfasst, um das Erstellen einer ansehbaren Videoaufzeichnung zu ermöglichen; und
Ausgeben von Steuersignalen, die mit den Kopierschutzsignalen zusammenfallen.

2. Verfahren nach Anspruch 1, bei dem der Schritt des Modifizierens umfasst:
Eingeben eines digitalen Videosignals in einen ersten Signaleingang eines Multiplexers;
Eingeben einer digitalen Zahl in einen zweiten Signaleingang des Multiplexers; und
Eingeben des Steuersignals in einen Steuereingang des Multiplexers.

3. Verfahren nach Anspruch 1, bei dem der Schritt des Modifizierens die Schritte umfasst:
Eingeben des Steuersignals in eine digitale Kopierschutzmodifizierschaltung während des Vorhandenseins von Kopierschutzsignalen in dem Videosignal; und
Steuern der Amplitude von Bereichen der Videosignale, um die Effekte der Kopierschutzsignale zu entfernen.

4. Verfahren nach Anspruch 3, bei dem der Schritt des Steuerns der Amplitude das Reduzieren der Amplitude von Bereichen des digitalen Videosignals während des Vorhandenseins von Kopierschutzsignalen umfasst.

5. Verfahren nach Anspruch 3, bei dem der Schritt des Steuerns der Amplitude das Erhöhen der Amplitude von Bereichen des digitalen Videosignals während des NichtVorhandenseins von Kopierschutzsignalen in dem Videosignal umfasst.

6. Verfahren nach Anspruch 1, bei dem der Schritt des Modifizierens die Schritte umfasst:
Eingeben des Steuersignals in eine digitale Kopierschutzmodifizierschaltung während des Vorhandenseins von Kopierschutzsignalen in dem Videosignal; und
Ersetzen der Kopierschutzsignale durch ein digitales Austauschsignal.

7. Verfahren nach Anspruch 6, bei dem das Austauschsignal ein digitales Signal ist, das den Ausblendpegel des Videosignals darstellt.

8. Verfahren nach einem der vorhergehenden Ansprüche, bei dem die Kopierschutzsignale Pseudosync- und AGC-Impulspaar-Kopierschutzsignale sind, und bei dem die Kopierschutzsignale durch Erhöhen der Amplitude von normalen
Sync-Impulsen relativ zu Pseudosync-Impulsen modifiziert werden, während sie sich in der digitalen Domäne befinden.

9. Verfahren nach einem der Ansprüche 1 bis 7, bei dem die Kopierschutzsignale in dem Videosignal Chroma-Kopierschutzsignale mit unpassender Phase sind, und bei dem die Kopierschutzsignale durch Ersetzen der Chroma-Kopierschutzsignale durch Chroma-Signale mit passender Phase modifiziert werden.

10. Verfahren nach Anspruch 9, bei dem die Position der Chroma-Kopierschutzsignale durch Bestimmen der Zeilen, in denen die Chroma-Kopierschutzsignale vorhanden sind, und durch Anordnen eines Burst-Gate-Signals bestimmt wird, das den Anfang eines Farbburst angibt.

11. Vorrichtung zum Entfernen der Effekte von Kopierschutzsignalen in einem Videosignal (12, 32, 52), bei der die Kopierschutzsignale das Erstellen von ansehbaren analogen Videoaufzeichnungen des Videosignals erschweren;
wobei die Vorrichtung aufweist:
einen digitalen Prozessor (34, 54) zum Empfangen eines digitalen Videosignals (12, 32, 52), das Kopierschutzsignale enthält;
einen digitalen Kopierschutzsignalpositionsdetektor (36, 56) zum Bestimmten, in welchen Zeilen des Videosignals die Kopierschutzsignale vorhanden sind;
eine Positionsschaltung zum digitalen Zählen einer vorbestimmten Zahl von Zeilen, in denen die Kopierschutzsignale vorhanden sind, und zum Ausgeben von Steuersignalen, die das Vorhandensein der Kopierschutzsignale angeben; und
eine digitale Signalmodifikatzonsschaltung (40, 58), die auf die Steuersignale anspricht, um die Kopierschutzsignale, während sie sich in der digitalen Domäne befinden, in mindestens einigen der Zeilen zu modifizieren, in denen die Kopierschutzsignale vorhanden sind, um das Erstellen einer ansehbaren Videoaufzeichnung des digitalen Videosignals zu ermöglichen, und zwar nach einer Digital-Analog-Umwandlung.

12. Vorrichtung nach Anspruch 11, bei der die Kopierschutzsignale Pseudosync- und AGC-Impulse sind, wobei die digitale Signalmodifikationsschaltung eine digitale Anti-Kopierschutzschaltung (58) aufweist, um die Kopierschutzsignale zu entfernen.

13. Vorrichtung nach Anspruch 12, bei der die Anti-Kopierschutzschaltung Mittel zur Pegelverschiebung der Pseudosync-Impulse relativ zu normalen Sync-Impulsen aufweist, um die Kopierschutzsignale zu modifizieren.

14. Vorrichtung nach Anspruch 12, bei der die Anti-Kopierschutzschaltung Mittel zur Impulsschmälerung der Pseudosync-Impulse und der AGC-Impulse aufweist.

15. Vorrichtung nach Anspruch 12, bei der die Anti-Kopierschutzschaltung Mittel zum Ersetzen aller Pseudosync-Impulse durch normale Sync-Impulse aufweist.

16. Vorrichtung nach Anspruch 12, bei der die Anti-Kopierschutzschaltung Mittel zum Erhöhen der Amplitude von normalen Sync-Impulsen relativ zu Pseudosync-Impulsen aufweist.

17. Vorrichtung nach Anspruch 11, bei der die Kopierschutzsignale Chroma-Kopierschutzsignale mit unpassender Phase in dem Videosignal sind, und bei der die digitale Signalmodifikationsschaltung einen digitalen Multiplexer (40, MUX10, MUX11) aufweist.

18. Vorrichtung nach Anspruch 17, bei der der digitale Kopierschutzsignalpositionsdetektor (36, 56) aufweist:
einen digitalen Komparator (DCP1) zum Empfangen des digitalen Videosignals, das die Chroma-Kopierschutzsignale enthält, der ausgestaltet ist, um ein Kompositsync zu erzeugen;
einen Zähler/Komparator/Timing-Generator (CCTG1), einen 2H-Eliminator/Timing-Generator (DTPG11) und einen ersten Zähler/Timing-Generator (DTPG12), die alle auf das Kompositsync ansprechen;
einen Rahmenimpuls-Generator(FPG1), der auf einen Pixeltakt zusammen mit dem Zähler/Komparator/Timing-Generator anspricht, und die erste sowie zweite Zähler/Timing-Generatorschaltung (DTPG13) auf den Pixeltakt ansprechen;
wobei der Zähler/Komparator/Timing-Generator einen vertikalen Impuls erzeugt, der mit dem Rahmenimpuls-Generator gekoppelt ist;
der Pixeltakt, die vertikalen Impuls- und Kompositsync-Signale mit dem Rahmenimpuls-Generator gekoppelt sind, um einen Rahmenimpuls zu erzeugen;
einen Rücksetz-525/625-Zähler (CNT1), der auf den Rahmenimpuls anspricht, um eine EPROM-Adresse zu erzeugen;
wobei der 2H-Eliminator/Timing-Generator horizontale Ratenimpulse erzeugt und mit dem Rücksetz-525/625-Zähler gekoppelt ist;
ein EPROM (21), das auf die EPROM-Adresse anspricht und so programmiert ist, dass ein ausgewählter Logikzustand Zeilen angibt, die die Chroma-Kopierschutzsignale enthalten;
wobei der erste und zweite Zähler-Generator kombiniert sind, um ein Burst-Gate-Signal an einem Ausgang des zweiten Zähler/Timing-Generators zu erzeugen.

19. Vorrichtung nach Anspruch 17, bei der die digitale Signalmodifikationsschaltung aufweist:
einen digitalen Multiplexer (MUX10, MUX11), um das Videosignal zu empfangen, das die Chroma-Kopierschutzsignale enthält;
einen digitalen Phasenschieber (Phase 10), der ausgestaltet ist, um das Videosignal auf einen zweiten Eingang des digitalen Multiplexers anzuwenden; und
ein UND-Gate (AND10), das auf ein Burst-Gate-Signal (BG) und ein Kopierschutzzeilenpositionssignal (Line Loc) anspricht, um ein Steuersignal an einen dritten Eingang des digitalen Multiplexers zu liefern, um die Zeitperioden zu steuern, während derer ein phasenverschobenes digitales Videosignal mit dem Ausgang des digitalen Multiplexers gekoppelt ist.

## Revendications

1. Procédé destiné à éliminer les effets de signaux de protection contre la copie dans un signal vidéo, où les signaux de protection contre la copie inhibent la réalisation d'enregistrements vidéo analogiques visionnables, le procédé comprenant les étapes qui consistent à :
déterminer dans quelles lignes du signal vidéo les signaux de protection contre la copie sont présents ;
compter un nombre prédéterminé de lignes dans une zone d'occultation verticale du signal vidéo dans laquelle les signaux de protection contre la copie sont présents ;
modifier les signaux de protection contre la copie en étant dans le domaine numérique dans au moins une partie des lignes dans lesquelles les signaux de protection contre la copie sont présents pour permettre la réalisation d'un enregistrement vidéo visionnable dudit signal vidéo numérique après conversion numérique à analogique, où l'étape consistant à modifier les signaux de protection contre la copie comprend le fait de modifier moins que toutes les lignes dans lesquelles les signaux de protection contre la copie sont présents, mais modifier un nombre suffisant des lignes pour permettre la réalisation d'un enregistrement vidéo visionnable ; et
délivrer en sortie des signaux de commande qui coïncident avec lesdits signaux de protection contre la copie.

2. Procédé tel que revendiqué dans la revendication 1, dans lequel l'étape de modification comprend le fait :
d'entrer un signal vidéo numérique à une première entrée de signal d'un multiplexeur ;
d'entrer un nombre numérique dans une seconde entrée de signal dudit multiplexeur ; et
d'entrer ledit signal de commande dans une entrée de commande dudit multiplexeur.

3. Procédé tel que revendiqué dans la revendication 1, dans lequel l'étape de modification comprend les étapes consistant à :
entrer le signal de commande à un circuit numérique de modification de la protection contre la copie pendant la présence de signaux de protection contre la copie dans le signal vidéo ; et
commander l'amplitude de parties des signaux vidéo pour éliminer les effets des signaux de protection contre la copie.

4. Procédé tel que revendiqué dans la revendication 3, dans lequel l'étape de commande de l'amplitude comprend le fait de réduire l'amplitude de parties du signal vidéo numérique pendant la présence de signaux de protection contre la copie.

5. Procédé tel que revendiqué dans la revendication 3, dans lequel l'étape de commande de l'amplitude comprend le fait d'augmenter l'amplitude de parties du signal vidéo numérique pendant l'absence de signaux de protection contre la copie dans le signal vidéo.

6. Procédé tel que revendiqué dans la revendication 1, dans lequel l'étape de modification comprend les étapes qui consistent à :
entrer le signal de commande à un circuit numérique de modification de la protection contre la copie pendant la présence de signaux de protection contre la copie dans le signal vidéo ; et
remplacer les signaux de protection contre la copie par un signal de remplacement numérique.

7. Procédé tel que revendiqué dans la revendication 6, dans lequel le signal de remplacement est un signal numérique représentant le niveau d'occultation dudit signal vidéo.

8. Procédé tel que revendiqué dans l'une quelconque des revendications précédentes, dans lequel les signaux de protection contre la copie sont des signaux de protection contre la copie pseudo-synchronisés et d'impulsions appariées AGC, et dans lequel les signaux de protection contre la copie sont modifiés en augmentant l'amplitude d'impulsions de synchronisation normale par rapport à des impulsions pseudo-synchronisées en étant dans le domaine numérique.

9. Procédé tel que revendiqué dans l'une quelconque des revendications 1 à 7, dans lequel les signaux de protection contre la copie dans le signal vidéo sont des signaux de protection contre la copie de chrominance à phase incorrecte, et dans lequel les signaux de protection contre la copie sont modifiés en remplaçant les signaux de protection contre la copie de chrominance par des signaux de chrominance à phase correcte.

10. Procédé tel que revendiqué dans la revendication 9, dans lequel l'emplacement des signaux de protection contre la copie de chrominance est déterminé en déterminant les lignes dans lesquelles les signaux de protection contre la copie de chrominance sont situés et en situant un signal d'extracteur de salve indiquant le début d'une salve couleur.

11. Appareil destiné à éliminer les effets de signaux de protection contre la copie dans un signal vidéo (12, 32, 52), où les signaux de protection contre la copie inhibent la réalisation d'enregistrements vidéo analogiques visionnables du signal vidéo ;
l'appareil comprenant :
un processeur numérique (34, 54) pour recevoir un signal vidéo numérique (12, 32, 52) contenant des signaux de protection contre la copie ;
un détecteur d'emplacement numérique (36, 56) de signaux de protection contre la copie destiné à déterminer dans quelles lignes du signal vidéo les signaux de protection contre la copie sont présents ;
un circuit de localisation pour compter numériquement un nombre prédéterminé de lignes dans lesquelles les signaux de protection contre la copie sont présents et pour délivrer en sortie des signaux de commande indiquant la présence dudit signal de protection contre la copie ; et
un circuit de modification de signal numérique (40, 58) sensible auxdits signaux de commande pour modifier les signaux de protection contre la copie en étant dans le domaine numérique dans au moins une partie des lignes dans lesquelles les signaux de protection contre la copie sont présents pour permettre la réalisation d'un enregistrement vidéo visionnable dudit signal vidéo numérique après conversion numérique à analogique.

12. Appareil tel que revendiqué dans la revendication 11, où les signaux de protection contre la copie sont des impulsions pseudo-synchronisées et des impulsions AGC, où le circuit de modification de signal numérique comprend un circuit numérique anti-protection contre la copie (58) pour supprimer les signaux de protection contre la copie.

13. Appareil tel que revendiqué dans la revendication 12, dans lequel ledit circuit anti-protection contre la copie comprend un moyen pour déplacement de niveau des impulsions pseudo-synchronisées par rapport aux impulsions de synchronisation normale pour modifier les signaux de protection contre la copie.

14. Appareil tel que revendiqué dans la revendication 12, dans lequel ledit circuit anti-protection contre la copie comprend un moyen pour rétrécissement d'impulsions desdites impulsions pseudo-synchronisées et desdites impulsions AGC.

15. Appareil tel que revendiqué dans la revendication 12, dans lequel ledit circuit anti-protection contre la copie comprend un moyen pour remplacer toutes les impulsions pseudo-synchronisées par des impulsions de synchronisation normale.

16. Appareil tel que revendiqué dans la revendication 12, dans lequel ledit circuit anti-protection contre la copie comprend un moyen pour accroître l'amplitude d'impulsions de synchronisation normale par rapport aux impulsions pseudo-synchronisées.

17. Appareil tel que revendiqué dans la revendication 11, dans lequel les signaux de protection contre la copie sont des signaux de protection contre la copie de chrominance à phase incorrecte dans le signal vidéo, et le circuit de modification de signal numérique comprend un multiplexeur numérique (40, MUX10, MUX11).

18. Appareil tel que revendiqué dans la revendication 17, dans lequel ledit détecteur d'emplacement (36, 56) de signaux de protection contre la copie numérique comprend :
un comparateur numérique (DCP1) pour recevoir ledit signal vidéo numérique contenant lesdits signaux de protection contre la copie de chrominance et agencé pour générer une synchronisation composite ;
un compteur/comparateur/générateur de réglage (CCTG1), un générateur de réglage d'élimination 2H (DTPG11) et un premier générateur de réglage à compteur (DTPG12), tous sensibles à la synchronisation composite ;
un générateur d'impulsions de trames (FPG1) sensible à une horloge de pixels avec le compteur/comparateur/générateur de réglage et le premier et le second circuit générateur de réglage à compteur (DTPG13) sensibles à l'horloge de pixels ;
dans lequel ledit compteur/comparateur/générateur de réglage génère une impulsion verticale qui est couplée audit générateur d'impulsions de trame ;
ladite horloge de pixels, ladite impulsion verticale et signaux de synchronisation composite étant couplés audit générateur d'impulsions de trames pour produire une impulsion de trame ;
un compteur 525/625 de réinitialisation (CNT1) sensible à l'impulsion de trame pour produire une adresse EPROM ;
dans lequel ledit générateur de réglage d'élimination 2H produit des impulsions de cadence horizontale et est couplé audit compteur 525/625 de réinitialisation ;
un EPROM (21) sensible à l'adresse EPROM et programmé de sorte qu'un état logique sélectionné indique des lignes contenant lesdits signaux de protection contre la copie de chrominance ;
dans lequel lesdits premier et second générateurs à compteurs se combinent pour produire un signal d'extracteur de salve sur une sortie dudit second générateur de réglage à compteur.

19. Appareil tel que revendiqué dans la revendication 17, dans lequel ledit circuit de modification de signal numérique comprend :
un multiplexeur numérique (MUX10, MUX11) destiné à recevoir ledit signal vidéo contenant les signaux de protection contre la copie de chrominance ;
un déphaseur numérique (Phase 10) agencé pour appliquer le signal vidéo à une seconde entrée du multiplexeur numérique ; et
une porte ET (AND 10) sensible à un signal d'extracteur de salve (BG) et un signal d'emplacement de lignes de protection contre la copie (Line Loc) pour alimenter un signal de commande à une troisième entrée du multiplexeur numérique pour commander les périodes temporelles pendant lesquelles un signal vidéo numérique déphasé est couplé à la sortie du multiplexeur numérique.
